# EUROPÄISCHE PATENTANMELDUNG

(11) **EP 3 751 626 A1**
(43) Veröffentlichungstag der Anmeldung: **16.12.2020**
(21) Anmeldenummer: 19179351.2
(22) Anmeldetag: 11.06.2019
(51) Int. Cl.: H01L 33/00, H01L 33/62, H01L 23/00, H01L 33/54

(54) **VERFAHREN ZUR HERSTELLUNG ZUMINDEST EINER ELEKTRISCHEN VERBINDUNG AUF EINEM ELEKTRONISCHEN MODUL UND ELEKTRONISCHES MODUL**

(71) Anmelder: ZKW Group GmbH, 3250 Wieselburg (AT)
(72) Erfinder: Kieslinger, Dietmar, 2604 Theresienfeld (AT); Haiden, Christoph, 2630 Ternitz (AT); Winklehner, David, 1220 Wien (AT)
(74) Vertreter: Patentanwaltskanzlei Matschnig & Forsthuber OG

(57) **Zusammenfassung**

Ein Verfahren zur Herstellung zumindest einer elektrisch leitenden Verbindung (15) auf einem elektronischen Modul (1), nämlich zwischen zumindest einem Kontakt (7) eines auf einem Substrat (2) des Moduls (1) angeordneten, top-kontaktierten LED-Chips (3) und einem von diesem in Abstand gelegenen, durch eine Lücke (13) getrennten Leiterabschnitts (11), bei welchem eine die Lücke (13) überbrückende Isolierabstützung (14) zwischen dem Leiterabschnitt (11) und dem Kontakt (7) des LED-Chips (3) hergestellt wird und sodann zur Herstellung der elektrisch leitenden Verbindung (15) ein leitfähiges Material auf die Isolierabstützung (14) aufgebracht wird, wobei die Endabschnitte der elektrisch leitenden Verbindung (15) aus leitfähigem Material mit dem Kontakt (7) und mit dem Leiterabschnitt (11) elektrisch leitend verbunden werden und die Endabschnitte der Isolierabstützung (14) auf einer Teilfläche sowohl des Kontaktes (7) als auch des Leiterabschnittes (11) aufliegen sowie ein entsprechend ausgebildetes Modul (1).

## Beschreibung

Die vorliegende Erfindung betrifft ein Verfahren zur Herstellung zumindest einer elektrisch leitenden Verbindung auf einem elektronischen Modul, nämlich zwischen zumindest einem Kontakt eines auf einem Substrat des Moduls angeordneten, top-kontaktierten LED-Chips und einem von diesem in Abstand gelegenen, durch eine Lücke getrennten Leiterabschnitts.

Weiters betrifft die Erfindung ein elektronisches Modul mit zumindest einem, auf einem Substrat des Moduls angeordneten, top-kontaktierten LED-Chip mit zumindest einem Kontakt und zumindest einem, von diesem in Abstand gelegenen, durch eine Lücke getrennten Leiterabschnitt, wobei eine elektrisch leitenden Verbindung zwischen dem zumindest einem Kontakt und dem Leiterabschnitt vorgesehen ist.

Unter einem top-kontaktierten LED-Chip ist ein LED-Baustein zu verstehen, bei welchem Kontakte, z.B. Kontaktpads oder Leiterbahnen, auf derselben Seite angeordnet sind, welche auch die Abstrahlseite einer oder mehrerer LEDs ist. Oft handelt es sich dabei um die sogenannte COB-Technologie bzw. COB-LEDs, wobei COB ein Akronym für "Chip on Board" ist.

Die Verbindung eines Kontaktes, insbesondere eines Kontaktpads von top-kontaktierten LEDs mit einem anderen Leiterabschnitt, beispielsweise einem Kontaktpad einer FR4-Platine, erfolgt üblicherweise durch Drahtbonden, einem Verfahren, bei welchem dünne Drähte als elektrische Verbindungen zur Anwendung kommen, deren Enden beispielsweise mittels Ultraschall an ein Kontaktpad geschweißt werden. Alternativ können insbesondere auch leitende Bändchen zur Anwendung kommen, vor allem, falls höhere Ströme geführt werden sollen.

Das Drahtbonden erfordert im Allgemeinen ein besonderes Oberflächenfinish, wie ENIG-Leiterplattenoberflächen (Electroless Nickel Immersion Gold), die sehr empfindlich auf Kratzer, Risse und Verunreinigungen, z.B. Rückstände von Flussmittel, Resist oder Lotpaste etc. reagieren. Bei Anwendung dünner Bonddrähte ist eine nur geringe Oberflächenrauigkeit notwendig. Insbesondere können die bogenförmig geführten Bonddrähte auch das gewünschte Lichtbild nachteilig beeinflussen und sie erfordern zusätzlichen Bauraum. Der Neigungswinkel zwischen dem Substrat und LEDs muss im Allgemeinen kleiner als 15° sein und die Ausbildung höherer Stufen ist problematisch hinsichtlich der Bonddrahtverbindungen.

An Stelle von Bonddrahtverbindungen könnte man auch mittels 3D-Druck hergestellte leitfähige 3D-Druckermaterialien verwenden, doch ergeben sich hier Probleme, da die Herstellung von Leitungen an Flanken oder Überhängen kaum möglich ist, das Verfahren langsam arbeitet und schmälere Leiterbahnen auf diese Weise schwer herstellbar sind.

Es ist eine Aufgabe der Erfindung, ein kostengünstiges Verfahren der gegenständlichen Art zu schaffen, welches auch bei unterschiedlichen Geometrien des Moduls anwendbar ist, wobei keine Beeinträchtigung eines von LEDs zu erzeugenden Lichtbildes erfolgen soll.

Diese Aufgabe wird mit einem Verfahren der eingangs genannten Art erreicht, bei welchem erfindungsgemäß eine die Lücke überbrückende Isolierabstützung zwischen dem Leiterabschnitt und dem Kontakt des LED-Chips hergestellt wird und sodann zur Herstellung der elektrisch leitenden Verbindung ein leitfähiges Material auf die Isolierabstützung aufgebracht wird, wobei die Endabschnitte der elektrisch leitenden Verbindung aus leitfähigem Material mit dem Kontakt und mit dem Leiterabschnitt elektrisch leitend verbunden werden und die Endabschnitte der Isolierabstützung auf einer Teilfläche sowohl des Kontaktes als auch des Leiterabschnittes aufliegen.

Da die Endabschnitte der Isolierabstützung auf einer Teilfläche sowohl des Kontaktes als auch des Leiterabschnittes aufliegen, ergibt sich der zusätzliche Vorteil einer genügenden Auflagefläche der Isolierabstützung, welche eine sichere Verbindung auch im Falle thermisch bedingter geringer Bewegungen auf Grund unterschiedlicher Wärmeausdehnungskoeffizienten der verwendeten Materialien gewährleisten, sodass eine Spaltbildung vermieden werden kann.

Eine vorteilhafte Weiterbildung des erfindungs gemäßen Verfahrens zeichnet sich dadurch aus, dass die die Lücke überbrückende Isolierabstützung durch Auftragen eines isolierenden, die Lücke im Wesentlichen ausfüllenden Materials hergestellt wird. Man kann hierdurch eine mechanisch besonders stabile Ausbildung des Moduls erhalten.

Bei einer anderen zweckmäßigen Ausbildung ist vorgesehen, dass die die Lücke überbrückende Isolierabstützung durch Aufbringen einer isolierenden Brücke und Verbinden deren Enden mit dem Leiterabschnitt und dem Kontakt des LED-Chips hergestellt wird. In bevorzugter Weise werden in diesem Fall die Enden der als isolierenden Brücke ausgebildeten Isolierabstützung mit dem Leiterabschnitt und dem Kontakt des LED-Chips verklebt.

Bei einer bevorzugten Variante wird die elektrisch leitende Verbindung durch Auftragen eines aushärtbaren, elektrisch leitfähigen Materials hergestellt. Eine in diesem Fall zweckdienliche Variante sieht vor, dass die elektrisch leitende Verbindung durch Auftragen eines leitfähigen Materials mittels Schablonendrucks hergestellt wird.

Die gestellte Aufgabe wird auch mit einem elektronisches Modul der oben angegebenen Art gelöst, bei welchem erfindungsgemäß eine die Lücke überbrückende Isolierabstützung zwischen dem Leiterabschnitt und dem Kontakt des LED-Chips vorgesehen ist, auf dieser Isolierstütze ein leitfähiges Material für die elektrisch leitende Verbindung aufgebracht ist, wobei die Endabschnitte der elektrisch leitenden Verbindung aus leitfähigem Material mit dem Kontakt und mit dem Leiterabschnitt elektrisch leitend verbunden sind und die Endabschnitte der Isolierabstützung auf einer Teilfläche sowohl des Kontaktes als auch des Leiterabschnittes aufliegen.

Das erfindungsgemäße Modul stellt die bereits weiter oben erwähnten Vorteile zur Verfügung.

Auch hier ist es von Vorteil, wenn die die Lücke überbrückende Isolierabstützung aus einem isolierenden, die Lücke im Wesentlichen ausfüllenden Material besteht.

Bei einer zweckmäßigen Ausbildung ist vorgesehen, dass die die Lücke überbrückende Isolierabstützung aus einer isolierenden Brücke besteht, deren Enden mit dem Leiterabschnitt und dem Kontakt des LED-Chips verbunden sind. Dabei können mit Vorteil die Enden der isolierenden Brücke mit dem Leiterabschnitt und dem Kontakt des LED-Chips verklebt sein.

Bei einer bevorzugten Variante ist vorgesehen, dass die elektrisch leitende Verbindung aus einem aushärtbaren, elektrisch leitfähigen Material besteht.

Die Erfindung ist im Folgenden an Hand beispielsweiser Ausführungsformen näher erläutert, die in der Zeichnung veranschaulicht sind. In dieser zeigen
Fig. 1 einen Schnitt durch einen Teilbereich eines elektronischen Moduls, bei welchem auf einem Substrat ein top-kontaktierter LED-Chip angeordnet ist, der mit einem von diesem in Abstand gelegenen, durch eine Lücke getrennten Leiterabschnitt auf einer Leiterplatte verbunden ist,
Fig. 2 gleichfalls im Schnitt eine Ausbildung ähnlich Fig 1, bei welcher jedoch, im Gegensatz zu Fig. 2, die zu verbindenden Kontaktstellen im Wesentlichen auf gleicher Höhe liegen,
Fig. 3 im Schnitt eine Ausbildung ähnlich Fig 1, bei welcher jedoch die Isolierabstützung, welche die Lücke überbrückt, aus einer isolierenden Brücke besteht, und
Fig. 4 im Schnitt eine Ausbildung ähnlich Fig 3, bei welcher jedoch, im Gegensatz zu Fig. 3, die zu verbindenden Kontaktstellen im Wesentlichen auf gleicher Höhe liegen

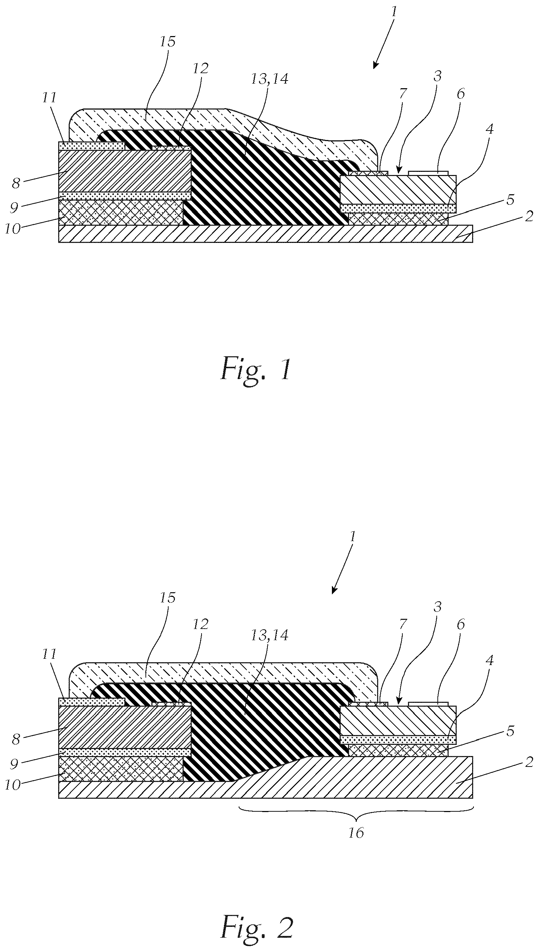

**Fig. 1** zeigt einen Teilbereich eines Moduls **1,** welches ein Substrat **2** aufweist, das im vorliegenden Beispiel ein Aluminium-Kühlkörper ist. Wenn im Zusammenhang mit der vorliegenden Erfindung der Begriff Substrat verwendet wird, so muss dieser sehr allgemein verstanden werden, wobei es sich, nur um Beispiele zu nennen, um einen Kühlkörper, eine Leiterplatte, eine Leiterplatte mit Kühlkörper, ein Keramiksubstrat, ein flexibles Substrat, einen Leiterrahmen (lead frame) und dgl. mehr handeln kann.

Auf dem Substrat 2 befindet sich ein top-kontaktierter LED-Chip **3,** der im vorliegenden Fall als Bodenkontakt **4** ein Boden-Pad, beispielsweise aus Gold, besitzt. Die Unterseite des Chips 3 mit dem Bodenkontakt 4 ist mit dem hier leitenden Kühlkörper/Substrat 2 aus Aluminium über eine Kleberschicht **5** verbunden. Im vorliegenden Fall handelt es sich um eine Leitkleberschicht, sodass eine elektrische Kontaktierung des Bodenkontaktes 4 mit dem Kühlkörper 2 aus Aluminium gegeben ist. Eine Licht abstrahlende Phosphorfläche **6** an der oberen Seite des Chip 6 ist gleichfalls eingezeichnet. Der Chip 3 besitzt weiters an seiner Oberseite einen Kontakt **7,** nämlich im Beispiel ein Kontaktpad aus Aluminium.

Der LED-Chip 3 besitzt im beschriebenen und gezeigten Beispiel einen Bodenkontakt 4 und einen Kontakt 7 an seiner Oberseite. Die Erfindung umfasst jedoch auch LED-Chips mit zwei oder mehr Kontakten an ihren Oberseiten, wobei die Chips keineswegs zwingend einen Bodenkontakt aufweisen müssen.

Auf dem Substrat 2 befindet sich weiters eine Leiterplatte **8,** beispielsweise eine FR4-Platte, deren Unterseite im gezeigten Beispiel eine Kupferschicht **9** aufweist, die mit dem Kühlkörper 2 aus Aluminium über eine Kleberschicht **10** verbunden. Es handelt es sich wieder um eine Leitkleberschicht, sodass eine elektrische Kontaktierung der Kupferschicht 9 mit dem Kühlkörper 2 aus Aluminium vorliegt. An der Oberseite der Leiterplatte 8 ist ein Leiterabschnitt **11** vorgesehen und man kann weiters eine Lötstopplackschicht **12** erkennen.

Der eigentliche Gegenstand der Erfindung ist nun die Schaffung einer elektrisch leitenden Verbindung zwischen dem Leiterabschnitt 11, bei dem es sich um ein übliches Kontaktpad handeln kann, mit dem Kontakt 7 des top-kontaktierten LED-Chips 3, der in Abstand von dem Leiterabschnitt 11 gelegen ist und außerdem durch eine Lücke **13** von diesem getrennt ist. Leiterabschnitt 11 und der Kontakt 7 des Chips 3 liegen überdies - bezogen auf das Substrat 2 - nicht auf gleicher Höhe.

Die Erfindung sieht nun hier vor, dass zunächst ein isolierendes Material zwischen dem Leiterabschnitt 11 und dem Kontakt 7 des LED-Chips 3 aufgetragen wird, welches die Lücke 13 im Wesentlichen ausfüllt, um so eine Isolierabstützung **14** zu schaffen. Sodann wird zur Herstellung einer elektrisch leitenden Verbindung **15** ein leitfähiges Material auf die Isolierabstützung 14 aufgebracht, wobei die Endabschnitte der elektrisch leitenden Verbindung 15 aus leitfähigem Material mit dem Kontakt 7 des Chips 3 und mit dem Leiterabschnitt 11 der Leiterplatte 8 elektrisch leitend verbunden sind und die Endabschnitte der Isolierabstützung 14 auf einer Teilfläche sowohl des Kontaktes 7 als auch des Leiterabschnittes 11 aufliegen.

Durch dieses Aufliegen der Endabschnitte der Isolierabstützung 14 ergibt sich der zusätzliche Vorteil einer genügenden Auflagefläche der Isolierabstützung sowohl an dem Kontakt 7 als auch an dem Leiterabschnitt 11, sodass sich eine sichere Verbindung auch im Falle thermisch bedingter geringer Bewegungen auf Grund unterschiedlicher Wärmeausdehnungskoeffizienten der verwendeten Materialien ergibt und beispielsweise eine Spaltbildung vermieden werden kann.

Für die Herstellung der elektrisch leitenden Verbindung 15 kann beispielsweise ein Silberleitkleber auf die Isolierabstützung 14 dispensiert und darnach ausgehärtet werden. Das Aushärten des leitfähigen Materials für die elektrisch leitende Verbindung kann gegebenenfalls gleichzeitig mit dem Aushärten des isolierenden Materials für die Isolierabstützung 14 erfolgen.

Die elektrisch leitende Verbindung 15 überwindet die räumliche Distanz zwischen dem Kontakt 7 des LED-Chips 3 und dem Leiterabschnitt 11 auf der Leiterplatte 8. Dabei wird im Allgemeinen eine Distanz entlang der Oberfläche sowie in der Höhe des Moduls 1 überwunden. Die Isolierabstützung 14 verhindert mögliche Kurzschlüsse der elektrisch leitenden Verbindung 15 mit dem Substrat 2, das in den gezeigten Beispielen elektrisch leitend ist, und des Weiteren dient die Isolierabstützung 14 als isolierende Brücke zum Geometrieausgleich, insbesondere wenn zu verbindenden Leiterabschnitte bzw. Kontaktpads auf unterschiedlicher Höhe liegen, wie bei der in Fig. 1 dargestellten Ausführungsform.

**Fig. 2** zeigt eine Ausführungsform der Erfindung, die sich von jener der Fig. 1 lediglich durch eine andere Geometrie des Substrats 2, der Lücke 13 mit der Isolierabstützung 14 bzw. der elektrisch leitenden Verbindung 15 unterscheidet. Um den Kontakt 7 auf dem LED-Chip 3 auf gleiche Höhe mit dem Leiterabschnitt 11 der Leiterplatte 8 zu bringen und dadurch das Auftragen des leitfähiges Material auf die Isolierabstützung 14 für die elektrisch leitende Verbindung 15 zu vereinfachen, besitzt das Substrat 2 in jenem Bereich oder Bereichen, in welchen der LED-Chip 3 angeordnet ist bzw. LED-Chips angeordnet sind, einen erhöhten bzw. verdickten Abschnitt **16** (oder Abschnitte). Dieser erhöhte Abschnitt gleicht den Höhenunterschied zwischen dem Kontakt 7 auf dem LED-Chip 3 und dem Leiterabschnitt 11 der Leiterplatte 8 aus, wodurch es beispielsweise möglich ist, das Aufbringen von Lotpaste oder Leitkleber mittels eines Druckverfahrens, z.B. mittels Schablonendruckes vorzunehmen.

Der Vorgang des Schablonendruckes beginnt damit, dass das Substrat 2, z.B. der Kühlkörper, auf einem Warenträger angeordnet wird, der geeignet ist, wie ein typischer Leiterplattennutzen durch eine SMT-Linie zu fahren (SMT= Surface Mounted Technology).

Eine unbestückte FR4 Leiterplatte 8 und der top-kontaktierte LED-Chip 3 werden im Vorfeld auf das Kühlkörper/Substrat 2 bestückt und fixiert, z.B. mittels eines auszuhärtenden Klebers. Dabei sollte sich die die Oberseiten des Kontaktes 7 auf dem LED-Chip 3 im Wesentlichen auf gleiche Höhe mit dem Leiterabschnitt 11 der Leiterplatte 8 befinden. Falls eine geringe Höhendifferenz vorliegt, kann diese mittels einer (Doppel-)Stufenschablone ausgeglichen werden.

Ein Höhenausgleich kann auch über die Dicke der Leiterplatte 8, die Höhe der Kleberschichten 5 und 10 unter den Komponenten oder durch Stufenstrukturen im Kühlkörper/Substrat 2 eingestellt werden. Zu den Größenverhältnissen sei angemerkt, dass die typische Höhe eines LED-Chips 0,7mm beträgt.

Für die lichtemittierende Fläche des LED-Chips ist eine entsprechende Ausnehmung notwendig, um diesen beim Rakeln nicht zu beschädigen. Die Druckschablone liegt somit auf der Leiterplatte 8 und am Gehäuse des LED-Chips 3 rund um die Phosphorfläche 6 auf.

Je nach Anzahl der gleichzeitig bedruckten Strukturen ergibt sich gegenüber einem Aufbringen von Lotpaste oder Leitkleber durch Dispensieren einzelner Punkte oder Linien bei einem Schablonendruck eine günstigere Taktzeit.

Wenngleich eine Ausbildung gemäß Fig. 2 für die Anwendung eines Druckverfahrens geeignet ist, können die Isolierabstützung 14 und die elektrisch leitende Verbindung 15 auch durch Dispergieren eines isolierenden Materials bzw. eines elektrisch leitenden Materials oder durch andere Verfahren hergestellt werden.

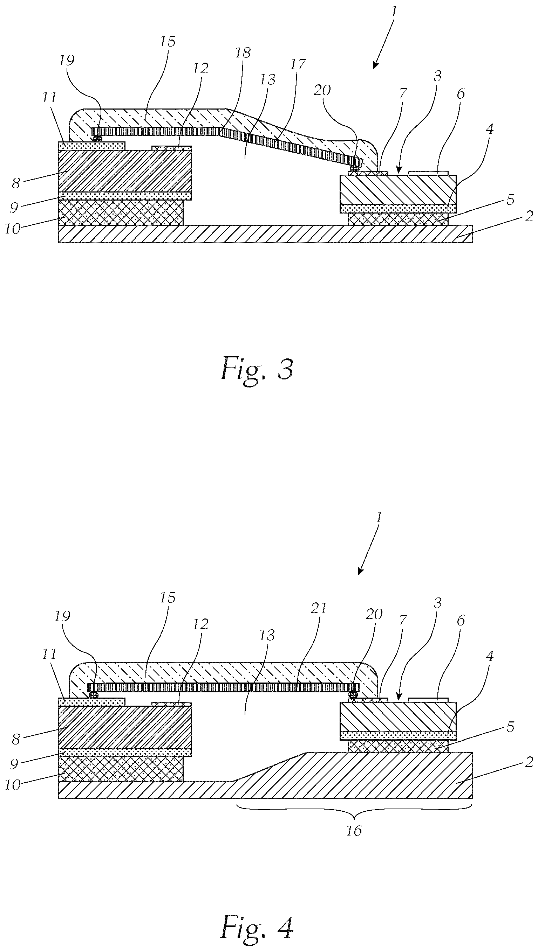

**Fig. 3** zeigt eine Ausbildung ähnlich Fig 1, bei welcher die gesamte Geometrie mit Ausnahme jener der Isolierabstützung und der elektrisch leitenden Verbindung der in Fig. 1 gezeigten gleicht, jedoch liegt hier eine andere Isolierabstützung **17** vor, welche die Lücke 13 überbrückt. Genauer gesagt ist bei der gezeigten Variante die Isolierabstützung 17 als isolierenden Brücke ausgebildet, wobei die Endabschnitte der Isolierabstützung 17 auf einer Teilfläche sowohl des Kontaktes 7 als auch des Leiterabschnittes 11 aufliegen. Die Endabschnitte der Isolierabstützung 17 sind auf die Teilflächen des Leiterabschnittes 11 der Leiterplatte 8 und des Kontaktes 7 des LED-Chips 3 mit Hilfe von Klebstofftropfen **19, 20** angeklebt.

Nach Verkleben der Endabschnitte der Isolierabstützung 17 mit den Teilflächen des Leiterabschnittes 11 der Leiterplatte 8 und des Kontaktes 7 des LED-Chips 3 wird zur Herstellung der elektrisch leitenden Verbindung 15 ein leitfähiges Material auf die Isolierabstützung 17 aufgebracht, wobei die Endabschnitte der elektrisch leitenden Verbindung 15 aus leitfähigem Material mit dem Kontakt 7 des Chips 3 und mit dem Leiterabschnitt 11 der Leiterplatte 8 elektrisch leitend verbunden sind.

Die Form und Länge der Isolierabstützung 17, nämlich der isolierenden Brücke wird zweckmäßigerweise der Geometrie des Aufbaues, insbesondere auch der Lücke 13, angepasst. Im gezeigten Beispiel weist die Isolierabstützung 17 einen nach oben gerichteten Knick **18** etwa in ihrer Längsmitte auf, wobei der in der Zeichnung links von dem Knick liegende Abschnitt der Isolierabstützung 17 im Wesentlichen horizontal verläuft und der in der Zeichnung rechts von dem Knick 18 liegende Abschnitt der Isolierabstützung 17 nach unten in Richtung des Kontaktes 7 des LED-Chips 3 geneigt ist.

Die Breite der Isolierabstützung 17 richtet sich einerseits nach den Abmessungen des Kontaktes 7 des Chips 3 bzw. des Leiterabschnittes 11 der Leiterplatte 8 und andererseits nach der geforderten Strombelastung. Bei Wahl der Dicke der Isolierabstützung 17 muss einerseits die geforderte Stabilität hinsichtlich des nachträglichen Aufbringens des leitfähigen Materials für die elektrisch leitende Verbindung 15 berücksichtigt werden und gegebenenfalls auch die Strombelastung.

**Fig. 4** zeigt eine Ausbildung ähnlich Fig 2, bei welcher die gesamte Geometrie mit Ausnahme jener der Isolierabstützung und der elektrisch leitenden Verbindung der in Fig. 2 gezeigten gleicht und es ist - ebenso wie gemäß Fig. 3 eine Isolierabstützung **21** vorgesehen, welche die Lücke 13 überbrückt und auf der die elektrisch leitende Verbindung 15 aufgebracht ist. Wie bei Fig. 2 besitzt das Substrat 2 in jenem Bereich oder Bereichen, in welchen der LED-Chip 3 angeordnet ist bzw. LED-Chips angeordnet sind, einen erhöhten bzw. verdickten Abschnitt 16 (oder Abschnitte) zum Ausgleich des Höhenunterschiedes.

Da entsprechend der Ausführung nach Fig. 2 der Kontakt 7 auf dem LED-Chip 3 auf zumindest annähernd gleicher Höhe mit dem Leiterabschnitt 11 der Leiterplatte 8 liegt, verläuft die Isolierabstützung 21 über ihre gesamte Länge zumindest im Wesentlichen horizontal und hinsichtlich der dadurch verbesserten Bedingungen für die Herstellung der elektrisch leitenden Verbindung 15 durch ein Druckverfahren gilt das dieser Hinsicht bereits in Verbindung mit Fig. 2 Gesagte. Für gleiche bzw. vergleichbare Teile, die in anderen Figuren gezeigt sind, wurden in Fig. 4 gleiche Bezugszeichen verwendet, was generell für die gesamte Beschreibung und Zeichnung gilt.

### Bezugszeichenliste

- 1: Modul
- 2: Substrat
- 3: LED-Chip
- 4: Boden-Kontakt
- 5: Kleberschicht
- 6: Phosphorfläche
- 7: Kontakt
- 8: Leiterplatte
- 9: Kupferschicht
- 10: Kleberschicht
- 11: Leiterabschnitt
- 12: Lötstopplackschicht
- 13: Lücke
- 14: Isolierabstützung
- 15: elektrisch leitende Verbindung
- 16: erhöhter bzw. verdickter Abschnitt
- 17: Isolierabstützung
- 18: Knick
- 19: Klebstofftropfen
- 20: Klebstofftropfen
- 21: Isolierabstützung

## Patentansprüche

1. Verfahren zur Herstellung zumindest einer elektrisch leitenden Verbindung (15) auf einem elektronischen Modul (1), nämlich zwischen zumindest einem Kontakt (7) eines auf einem Substrat (2) des Moduls angeordneten, top-kontaktierten LED-Chips (3) und einem von diesem in Abstand gelegenen, durch eine Lücke (13) getrennten Leiterabschnitts (11),
**dadurch gekennzeichnet, dass**
eine die Lücke (13) überbrückende Isolierabstützung (14, 17, 21) zwischen dem Leiterabschnitt (11) und dem Kontakt (7) des LED-Chips (3) hergestellt wird und sodann zur Herstellung der elektrisch leitenden Verbindung (15) ein leitfähiges Material auf die Isolierabstützung aufgebracht wird, wobei die Endabschnitte der elektrisch leitenden Verbindung (15) aus leitfähigem Material mit dem Kontakt und mit dem Leiterabschnitt elektrisch leitend verbunden werden und die Endabschnitte der Isolierabstützung auf einer Teilfläche sowohl des Kontaktes als auch des Leiterabschnittes aufliegen.

2. Verfahren nach Anspruch 1, **dadurch gekennzeichnet, dass** die die Lücke (13) überbrückende Isolierabstützung (14) durch Auftragen eines isolierenden, die Lücke im Wesentlichen ausfüllenden Materials hergestellt wird.

3. Verfahren nach Anspruch 1, **dadurch gekennzeichnet, dass** die die Lücke (13) überbrückende Isolierabstützung (17, 21) durch Aufbringen einer isolierenden Brücke und Verbinden deren Enden mit dem Leiterabschnitt (11) und dem Kontakt (7) des LED-Chips (3) hergestellt wird.

4. Verfahren nach Anspruch 3, **dadurch gekennzeichnet, dass** die Enden der als isolierenden Brücke ausgebildeten Isolierabstützung (17, 21) mit dem Leiterabschnitt (11) und dem Kontakt (7) des LED-Chips (3) verklebt werden.

5. Verfahren nach einem Ansprüche 1 bis 4, **dadurch gekennzeichnet, dass** die elektrisch leitende Verbindung (15) durch Auftragen eines aushärtbaren, elektrisch leitfähigen Materials hergestellt wird.

6. Verfahren nach Anspruch 5, **dadurch gekennzeichnet, dass** die elektrisch leitende Verbindung (15) durch Auftragen eines leitfähigen Materials mittels Schablonendrucks hergestellt wird.

7. Elektronisches Modul (1) mit zumindest einem, auf einem Substrat (2) des Moduls angeordneten, top-kontaktierten LED-Chip (3) mit zumindest einem Kontakt (7) und zumindest einem, von diesem in Abstand gelegenen, durch eine Lücke (13) getrennten Leiterabschnitt (11), wobei eine elektrisch leitenden Verbindung (15) zwischen dem zumindest einem Kontakt (7) und dem Leiterabschnitt vorgesehen ist,
**dadurch gekennzeichnet, dass**
eine die Lücke (13) überbrückende Isolierabstützung (14, 17, 21) zwischen dem Leiterabschnitt (11) und dem zumindest einem Kontakt (7) des LED-Chips (3) vorgesehen ist, auf dieser Isolierstütze für die elektrisch leitende Verbindung (15) ein leitfähiges Material aufgebracht ist, wobei die Endabschnitte der elektrisch leitenden Verbindung (15) aus leitfähigem Material mit dem Kontakt und mit dem Leiterabschnitt elektrisch leitend verbunden sind und die Endabschnitte der Isolierabstützung auf einer Teilfläche sowohl des Kontaktes als auch des Leiterabschnittes aufliegen.

8. Elektronisches Modul (1) nach Anspruch 7, **dadurch gekennzeichnet, dass** die die Lücke (13) überbrückende Isolierabstützung (14) aus einem isolierenden, die Lücke im Wesentlichen ausfüllenden Material besteht.

9. Elektronisches Modul (1) nach Anspruch 7, **dadurch gekennzeichnet, dass** die die Lücke (13) überbrückende Isolierabstützung (17, 21) aus einer isolierenden Brücke besteht, deren Enden mit dem Leiterabschnitt und dem Kontakt des LED-Chips verbunden sind.

10. Elektronisches Modul (1) nach Anspruch 9, **dadurch gekennzeichnet, dass** die Enden der isolierenden Brücke (17, 21) mit dem Leiterabschnitt und dem Kontakt des LED-Chips verklebt sind.

11. Elektronisches Modul (1) nach einem Ansprüche 7 bis 10, **dadurch gekennzeichnet, dass** die elektrisch leitende Verbindung (15) aus einem aushärtbaren, elektrisch leitfähigen Material besteht.
